# EUROPÄISCHE PATENTSCHRIFT

(11) **EP 2 637 487 B1**
(45) Veröffentlichungstag und Bekanntmachung des Hinweises auf die Patenterteilung: **16.07.2014**
(21) Anmeldenummer: 12001476.6
(22) Anmeldetag: 05.03.2012
(51) Int. Cl.: H05K 7/20

(54) **Klimagerät zur Kühlung von Elektronikgeräten oder Elektronikgeräteschränken mit Blech zur verbesserten Luftführung**
Air conditioning device for cooling electronics components or electronics cabinets with sheet metal for improved ventilation
Appareil de climatisation destiné au refroidissement d'appareils électroniques ou d'armoires d'instruments électroniques avec tôle pour améliorer la ventilation

(43) Veröffentlichungstag der Anmeldung: 11.09.2013
(73) Patentinhaber: STULZ GmbH, D-22457 Hamburg (DE)
(72) Erfinder: Hülskamp, Stephan, 21220 Seevetal/Ramelsloh (DE); Beyer, Sebastian, 22844 Norderstedt (DE)
(74) Vertreter: Kossak, Sabine

(56) Entgegenhaltungen:
- WO-A1-2009/141610
- WO-A2-2008/039773
- DE-A1-102008 002 789
- DE-C1- 4 309 308

## Beschreibung

Gegenstand der Erfindung ist ein Klimagerät zum Kühlen von Luft für ein Elektronikgerät oder einen Elektronikgeräteschrank, aufweisend ein Gehäuse mit einer Vorderseite und einer der Vorderseite gegenüberliegenden Rückseite, mindestens einen Ventilator und einen Wärmetauscher, wobei der Ventilator Luft von der Rückseite ansaugt, durch den Wärmetauscher zur Vorderseite leitet und in radialer Richtung an der Vorderseite abgibt, wobei der Wärmetauscher mit einer externen Kühleinrichtung oder einer internen Kühleinrichtung zum Beaufschlagen des Wärmetauschers mit gekühltem Kühlmedium in Verbindung steht.

Für den sicheren Betrieb von Elektronikgeräten, wie zum Beispiel Servern insbesondere in Rechenzentren oder Fertigungsanlagen ist es notwendig, diese ausreichend zu kühlen. Die Kühlung erfolgt üblicherweise mit Klimageräten, die ausreichend Kühlluft bereit stellen, welche mit Hilfe von Ventilatoren zu den Elektronikgeräten und durch die Elektronikgeräte geleitet wird. Dabei nimmt die Kühlluft die Abwärme beziehungsweise Wärme der elektronischen Komponenten auf und regelt so die Betriebstemperatur der Elektronikgeräte. Ein besonderer Bedarf für solche Klimageräte besteht in Rechenzentren und in Fertigungsanlagen, in denen eine große Zahl von Elektronikgeräten untergebracht ist, um eine hohe Rechenleistung pro Raumeinheit gewährleisten zu können. In diesen Rechenzentren und Fertigungsanlagen werden die Elektronikgeräte üblicherweise in sogenannten Racks, Elektronikgeräteschränken mit standardisierten Rastermaßen, untergebracht. Die Racks weisen dabei häufig Raum für eine Vielzahl von dicht übereinander gestapelten Elektronikgeräten auf. Es besteht daher ein Bedarf, zuverlässig und dauerhaft eine ausreichende Menge Kühlluft bereit zu stellen, ohne dass hierfür ein großer Bauraum beansprucht wird.

In modernen Rechenzentren werden mehrere durch Gänge voneinander beabstandete Reihen bestehend aus zueinander benachbarten Racks in einem Raum angeordnet, wobei üblicherweise die Fronten der Racks einer ersten Reihe zu den Fronten der Racks der benachbarten Reihe ausgerichtet sind. Üblicherweise weisen die Fronten Lufteinlässe auf, über die kühle Luft zur Kühlung der Elektronikgeräte eingesaugt wird. Die Gänge, zu denen die Fronten mit den Lufteinlässen weisen, werden deshalb auch als "Kaltgang" oder "kühler Gang" bezeichnet. Die kühle Luft strömt durch die elektronischen Geräten, nimmt dabei die Wärme aus den Geräten auf und wird an der Rückseite der Elektronikgeräteschränke beziehungsweise Racks in den nächsten Gang wieder abgegeben. Dieser Gang wird deshalb als "warmer Gang" oder "Heißgang" bezeichnet. Entsprechend müssen Klimageräte vorhanden sein, die kühle Luft in die kalten Gänge leiten. Dieses kann beispielsweise herunter gekühlte Luft aus den "Heißgängen" sein. Eine entsprechende Anordnung ist beispielsweise aus der DE 10 2008 002 789 A1 bekannt.

Es ist bekannt, Klimageräte zwischen den Racks für die Elektronikgeräte wie zum Beispiel Servern anzuordnen. Die Luft aus den Klimageräten wird dabei senkrecht zur Front des Klimagerätes beziehungsweise der benachbarten Racks in den "Kaltgang" eingeblasen.

Ein entsprechendes Klimagerät ist beispielsweise in der WO 2009/141610 A1 beschrieben. Diese Kühleinrichtung ist so beschaffen, dass sie zu den Fronten der Elektronikgeräteschränke in einer versetzten Position eingebaut werden kann. Dabei ragt die Luftfördereinrichtung über die Frontseite der Server Racks hinaus.

Bei diesen Klimatisierungsvorrichtungen und weiteren Klimatisierungsvorrichtungen aus dem Stand der Technik ist nachteilig, dass die gekühlte Luft nicht optimal zu den zu kühlenden Elektronikgeräten geleitet wird. Hierdurch erfolgt eine Durchmischung von kalter und warmer Luft, die zu einem niedrigeren Wirkungsgrad der Klimageräte führt.

Auch aus der WO 2008/039773 A2 ist eine nachteilige Luftführung bekannt. Aus einem zentralen Gang zwischen den Elektronikgeräten wird die gekühlte Luft durch die Computer geleitet und an deren Rückseiten ausgeleitet. Durch Ventilatoren in den Klimatisierungsvorrichtungen wird die warme Luft von den Rückseiten der Elektronikgeräte angesaugt, mittels Kühlvorrichtungen gekühlt und auf der Vorderseite wieder in den zentralen Gang ausgeleitet. Auch hier wird die gekühlte Luft nicht eng an den Elektronikgerätefronten entlang geführt.

Zur Verbesserung der Luftführung werden daher teilweise Luftführungsbleche eingesetzt. Eine Variante von Luftführungsblechen ist beispielsweise aus der US 2006/0139877A1 bekannt. Luftführungsbleche werden an der Ausströmöffnung vor dem Ventilator angebracht und dienen dazu, die Luft umzuleiten und an den Fronten der Racks entlangzuführen. Der Nachteil dieser Ausführung ist, dass zusätzliche externe Bauteile an den Klimageräten in Form von Luftführungsblechen notwendig sind, die jeweils an die genaue Aufstellung und Geometrie angepasst werden müssen. Die Klimageräte sind für den jeweiligen Einsatzort ausgelegt und können nicht ohne Umbauten variabel für einen anderen Einsatzort verwendet werden.

Aufgabe der vorliegenden Erfindung ist es daher, ein Klimagerät zur Kühlung von Luft für Racks wie zum Beispiel Serverracks bereitzustellen, die einen hohen Wirkungsgrad haben, die Durchmischung von kalter und warmer Luft verringern und eine variable Aufstellung durch Vermeidung von externen Luftführungsblechen erlauben. Dabei soll die bereitgestellte Kühlluft möglichst direkt auf kurzem Wege vom Klimagerät zu den einzelnen Elektronikgeräten gelangen, auch wenn das Klimagerät als eigenständige, unabhängige Einheit (stand-alone-Gerät) ausgeführt ist.

Die Aufgabe wird erfindungsgemäß gelöst durch ein Klimagerät zum Kühlen von Luft für einen Elektronikgeräteschrank oder dergleichen, wobei das Klimagerät ein Klimagerät zur Anordnung zwischen Elektronikgeräteschränken oder dergleichen ist, aufweisend
- ein Gehäuse mit einer Vorderseite und einer der Vorderseite gegenüberliegenden Rückseite,
- mindestens ein Radialgebläse z.B. einen Ventilator und
- einen Wärmetauscher,
wobei der Wärmetauscher mit einer externen Kühleinrichtung oder einer internen Kühleinrichtung zum Beaufschlagen des Wärmetauschers mit gekühltem Kühlmedium in Verbindung steht,
wobei das Radialgebläse Luft von der Rückseite ansaugt, in Kontakt mit einem Wärmetauscher bringt und zur Vorderseite leitet und in radialer Richtung an der Vorderseite abgibt, so dass der austretende Kühlluftstrom sich an den Oberflächen benachbarter Elektronikgeräteschränkefronten entlang bewegen kann,
dadurch gekennzeichnet, dass
mindestens ein Blech unterhalb oder oberhalb mindestens eines der Radialgebläse angeordnet ist, wobei das Blech drei miteinander verbundene Abschnitte aufweist, einen ersten bogenförmigen Abschnitt, einen geraden Abschnitt und einen zweiten bogenförmigen Abschnitt und der erste und zweite bogenförmige Abschnitt punktsymmetrisch zueinander und zueinander kongruent angeordnet und entlang der Rundung der Radialgebläse angeordnet sind.

Bevorzugte Ausführungsformen sind Gegenstand der Unteransprüche oder nachfolgend beschrieben.

Die Ausleitung der gekühlten Luft aus dem Klimagerät in radialer Richtung bewirkt, dass der austretende Kühlluftstrom sich an den Oberflächen der benachbarten Elektronikgeräteschränkefronten entlang bewegt und sich an die Oberflächen anlegt. Dieser Effekt, dass sich die Luftströmung an die Fronten anlegt, ist nach dem Entdecker Henry Coanda als Coanda-Effekt bekannt. Hierdurch bleibt die kalte Luft stets nahe an den zu kühlenden Geräten und vermischt sich nicht oder nur wenig mit der im Kaltgang bereits befindlichen Luft. Ein solches Klimagerät, dass eine effektive Kühlung unter Einsatz des Coanda-Effekts ermöglicht ist in der EP 2 434 853 beschrieben, auf deren Inhalt hiermit ausdrücklich Bezug genommen wird. Das erfindungsgemäße Klimagerät stellt eine Weiterentwicklung dieses Geräts dar.

Es hat sich jedoch gezeigt, dass aufgrund der Geometrie der üblicherweise verwendeten Ventilatoren die Luftströmung an der Frontseite der Racks diagonal zum Boden erfolgt. Hierdurch werden die Elektronikgeräte, die sich in der einen oberen Ecke beziehungsweise in der gegenüberliegenden unteren Ecke befinden, nicht optimal gekühlt. Ebenso hat sich gezeigt, dass es bei zwei oder mehreren nebeneinander oder übereinander platzierten Ventilatoren zur Überschneidung der von den Ventilatoren erzeugten Luftströmung und zu Verwirbelungen kommt.

Das Blech weist in einer Ausführungsform einen Querschnitt auf, der dem Graph einer Polynomfunktion, insbesondere dem Graph der Funktion x^{y} mit y gleich einer Zahl zwischen 3 und 10, besonders bevorzugt x³ entspricht. Der Querschnitt entspricht somit einer punktsymmetrischen Form, die in der Nähe des Symmetriezentrums eine gerade Linie ist. Die Länge des geraden Abschnitts ebenso wie die Biegung und Länge der bogenförmigen Abschnitte hängen dabei von den Abmessungen des Klimagerätes ab. In einer bevorzugten Ausführungsform ist die Längenausdehnung der bogenförmigen Abschnitte jeweils 2/3 so groß wie die Länge der geraden Abschnitte. Beispielsweise beträgt die Breite des geraden Abschnitts 100-130 mm, insbesondere 120 mm, und die Breite des bogenförmigen Abschnitts 75 - 90mm, insbesondere 80 bis 85 mm.

In einer Ausführungsform weisen die bogenförmigen Abschnitte eine Höhe h von 95 - 105 mm auf. Die Gesamtbreite des Blechs a ergibt sich aus den Breiten der beiden bogenförmigen Abschnitte b und der Breite des geraden Abschnitts c.

In einer weiteren Ausführungsform entspricht der Querschnitt des Blechs für den ersten bogenförmigen Abschnitt und dem zweiten bogenförmigen Abschnitt einem Viertel eines Kreisbogens. Der Gesamtquerschnitt des Blechs setzt sich somit aus einem Viertel-Kreisbogen, einer geraden Linie und einem zweiten Viertel-Kreisbogen, der in die andere Richtung gebogen ist, zusammen.

Bevorzugt weist das Blech eine Wellenform beziehungsweise einen S-förmigen Querschnitt auf. Unter S-förmig im Sinne der Erfindung wird dabei ein S mit vergleichsweise weiten Bögen, die nach außen gestreckt sind, verstanden.

Das erfindungsgemäße Klimagerät weist bevorzugt ein bis fünf Radialgebläse, besonders bevorzugt drei bis vier Radialgebläse auf. Bei der Ausführungsform mit drei Radialgebläsen weist das erfindungsgemäße Klimagerät zwei Bleche auf. Die Bleche sind jeweils zwischen zwei Radialgebläsen angeordnet. Bevorzugt sind die Radialgebläse übereinander auf verschiedenen Höhen in einem Klimagerät angeordnet.

Die bogenförmigen Abschnitte des Blechs sind entlang der Rundung der Radialgebläse angeordnet. Die Bleche sind bevorzugt so zwischen den Radialgebläsen angeordnet, dass der gerade Abschnitt der Bleche auf der Spiegelachse zwischen den Radialgebläsen liegt.

In einer Ausführungsform werden bevorzugt Radialgebläse mit einem Radialgebläsedurchmesser von 220 bis 355 mm besonders bevorzugt 310 mm oder 355 mm, eingesetzt. Bevorzugt werden Radialgebläse mit Schaufeln, die rückwärts oder vorwärts gekrümmt sind, eingesetzt. Besonders bevorzugt sind Ventilatoren mit rückwärts gekrümmten Schaufeln.

Die Bleche sind bevorzugt so angeordnet, dass der zum Radialgebläse gerichtete bogenförmige Abschnitt in seiner Krümmung der Drehrichtung des Radialgebläses entspricht.

Das erfindungsgemäße Klimagerät wird bevorzugt neben ein oder mehrere Racks oder zwischen mindestens zwei Racks platziert. Abhängig davon, ob Racks nur auf einer Seite neben dem Klimagerät oder auf beiden Seiten neben dem Klimagerät platziert sind, wird die Luft radial zu einer oder zu beiden Seiten aus dem Klimagerät geführt. Das Klimagerät wird dabei bevorzugt so neben oder zwischen die Racks platziert, dass der vordere Bereich des Klimagerätes, in dem der oder die Radialgebläse angeordnet sind, vor die Fronten der Racks vorgezogen ist. Im eingebauten Zustand steht das Klimagerät im Vergleich zu den benachbarten Racks somit nach vorne zur Vorderseite vorgezogen. Aufgrund dieser Platzierung streicht die gekühlte Luft aus den Radialgebläsen, die radial abgeben wird, an den Fronten der Elektronikgeräteschränke entlang und legt sich aufgrund des Coanda-Effekts an die Fronten an. Das erfindungsgemäße Klimagerät ist bevorzugt als stand-alone-Gerät ausgeführt.

Das erfindungsgemäße Klimagerät ist aufgrund des zusätzlichen Strömungsblechs besonders effizient. Zusätzlich zu der radialen Ausleitung der Kühlluft, die aufgrund des Coanda-Effekts eine hohe Effektivität aufweist, wird die Kühlluft entlang der Fronten auch gleichmäßiger verteilt. Zudem ist die Strömungsgeschwindigkeit der ausströmenden Kaltluft höher, so dass eine höhere Reichweite erreicht wird. Entsprechend kann eine größere Fläche mit der Kühlluft beaufschlagt werden.

Die erfindungsgemäßen Klimageräte können in Rechenzentren mit oder ohne Doppelboden eingesetzt werden. Bevorzugt werden die Klimageräte neben den Racks, Elektronikgeräteschränken mit bevorzugt standardisierten Abmessungen, platziert.

Durch die Verwendung mindestens eines Blechs bei dem erfindungsgemäßen Klimagerät wird die Luftführung optimiert und die Luft strömt an der Vorderseite der Racks in horizontaler Richtung ab, so dass auch die Elektronikgeräte in der oberen beziehungsweise der gegenüberliegenden unteren Ecke gekühlt werden. Durch die gleichmäßigere Luftverteilung in horizontaler Richtung wird die Luft, die über die Oberseite des Racks hinaus transportiert wird, auf ein Minimum reduziert, so dass es zu weniger Durchmischung von kalter und warmer Luft kommt.

Der Wärmetauscher des erfindungsgemäßen Klimageräts steht mit einer externen Kühleinrichtung oder einen internen Kühleinrichtung zum Beaufschlagen des Wärmetauschers mit gekühltem Kühlmedium in Verbindung. Solche Kühleinrichtungen sind beispielweise Kompressorkühlungen mit einem Kältemittel, Kaltwasserkühlungen, Systeme mit Kühlwasserkreislauf oder Systeme mit indirekter freier Kühlung. Das Klimagerät weist ferner abhängig von der Ausführungsform mindestens eine Leitung zum Verbinden des Wärmetauschers mit einer zentralen Kühleinrichtung auf.

Bevorzugt weist der Wärmetauscher im erfindungsgemäßen Klimagerät mehrere jeweils individuell regelbare Wärmetauschersegmente auf verschiedenen Höhen aufweist.

In einer Ausführungsform weist das Klimagerät ferner einen vorspringenden Rahmen auf, in dem das oder die Radialgebläse angeordnet sind.

Bevorzugt ist der durch die Radialgebläse verursachte Luftvolumenstrom regelbar, insbesondere für jedes Radialgebläse im Klimagerät individuell regelbar.

Die Erfindung wird anhand der nachfolgenden Figuren beispielhaft näher erläutert.

Es zeigt
- Figur 1: eine perspektivische Darstellung eines erfindungsgemäßen Klimageräts,
- Figur 2: ein Querschnitt durch ein Blech des erfindungsgemäßen Klimageräts,
- Figur 3: ein Strömungsprofil der Kühlluftströmung eines nicht erfindungsgemäßen Klimageräts ohne Bleche und
- Figur 4: ein Strömungsprofil der Kühlluftströmung mit erfindungsgemäßem Blech.

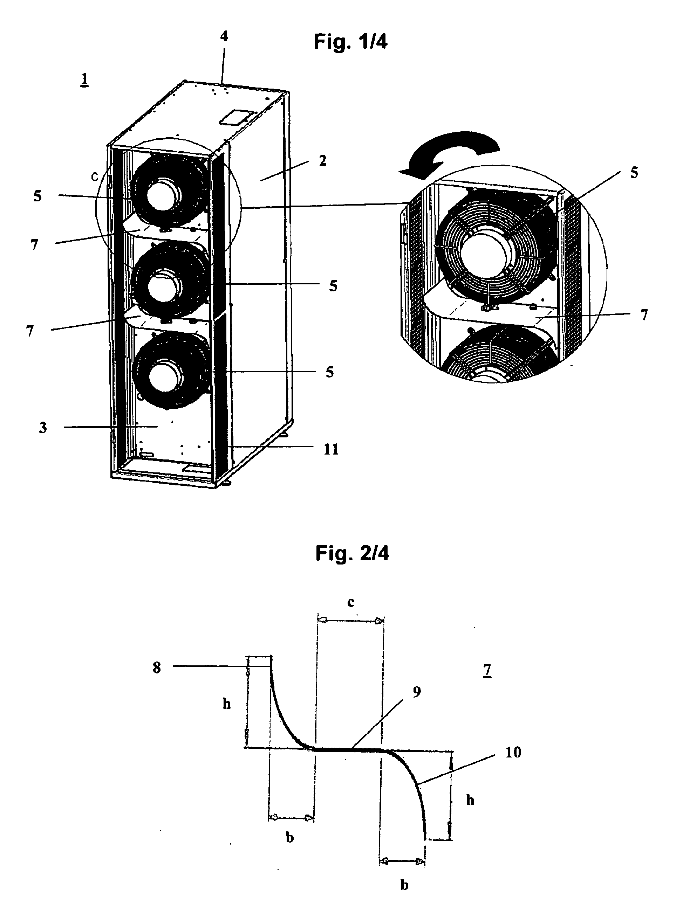

Figur 1 zeigt eine Ausführungsform des erfindungsgemäßen Klimageräts 1. Das Klimagerät weist ein Gehäuse 2 mit einer Vorderseite 3 und einer Rückseite 4 auf. An der Vorderseite 3 des Klimageräts 1 sind Radialgebläse (Ventilatoren) 5 angeordnet. Zwischen den Ventilatoren 5 sind Bleche 7 erkennbar. Das Klimagerät 1 umfasst zudem einen nicht dargestellten Wärmetauscher 6. Luft wird von der Rückseite 4 mittels der Ventilatoren 5 in das Klimagerät 1 gesogen, strömt an dem mit Kühlmedium beaufschlagten Wärmetauscher 6 entlang und wird gekühlt. Die Luft verlässt das Klimagerät durch Öffnungen 11 in radialer Richtung.

Figur 2 zeigt einen Querschnitt durch ein erfindungsgemäßes Blech 7. Der Querschnitt des Blechs 7 entspricht dabei etwa dem Graph der Funktion x³. Es ist erkennbar, dass das Blech 7 einen ersten bogenförmigen Abschnitt 8, der mit dem zweiten geraden Abschnitt 9 verbunden ist, aufweist. Der zweite gerade Abschnitt 9 ist in seiner zweiten Seite mit einem dritten bogenförmigen Abschnitt 10 verbunden. Die bogenförmigen Abschnitte 8 und 10 sind dabei deckungsgleich. Die bogenförmigen Abschnitte 8,10 weisen eine bestimmte Höhe h sowie eine bestimmte Breite b auf. Die Breite b der bogenförmigen Abschnitte 8 und 10 ist geringer als die Breite c des geraden Abschnitts 9.

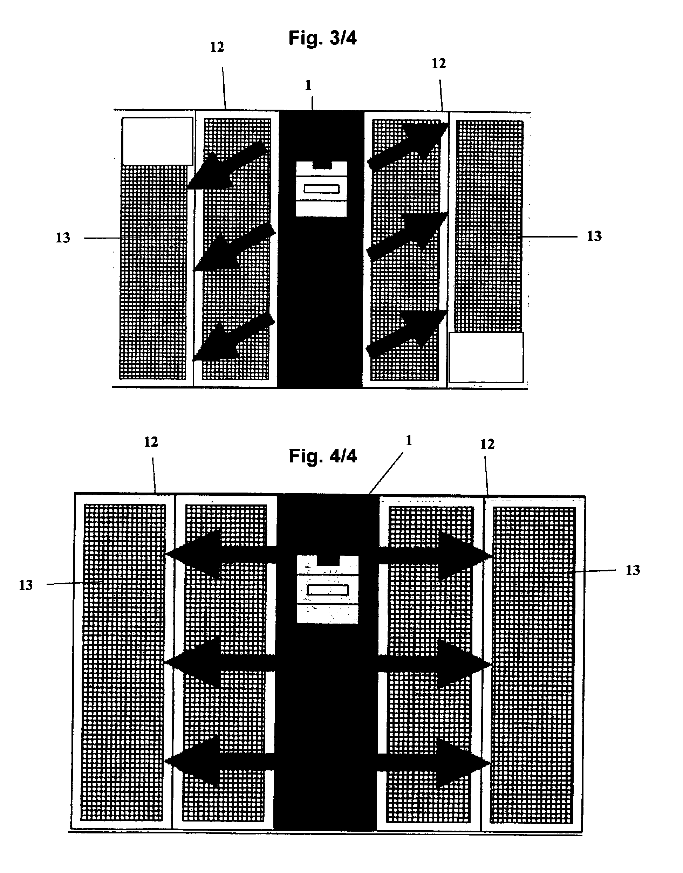

Figur 3 zeigt das Strömungsprofil eines Klimageräts mit einem Radialgebläse, der die gekühlte Luft in radialer Richtung entlang der Fronten der Racks abgibt. Die Luftströmung ist durch Pfeile kenntlich gemacht. Es ist erkennbar, dass die Luft im Wesentlichen in diagonaler Richtung an den Fronten der Racks entlang strömt. Hierdurch kommt es zu einer verminderten Kühlleistung im Bereich der oberen linken Ecke der Racks, ebenso wie im Bereich der unteren rechten Ecke der Racks, was durch weiße Flächen dargestellt ist. Zudem wird ein Teil der Kühlluft auf der rechten Seite über die Oberseite der Racks hinaus geblasen, was zu zusätzlichen Luftverwirbelungen und Vermischung von warmer und kalter Luft auch im benachbarten Heißgang führen kann.

Figur 4 zeigt die Luftströmung bei der Verwendung eines erfindungsgemäßen Klimageräts 1. Die Luft wird aus dem Klimagerät 1 in waagerechter Richtung entlang der Pfeile an den Fronten 13 der Racks 12 abgegeben. Hierdurch wird eine gleichmäßigere Kühlleistung erreicht, die Strömungsgeschwindigkeit wird höher und es entstehen weniger Verwirbelungen.

### Bezugszeichenliste

- 1: Klimagerät
- 2: Gehäuse
- 3: Vorderseite
- 4: Rückseite
- 5: Radialgebläse
- 6: Wärmetauscher
- 7: Blech
- 8: erster bogenförmiger Abschnitt
- 9: gerader Abschnitt
- 10: zweiter bogenförmiger Abschnitt
- 11: Öffnungen
- 12: Elektronikgeräteschrank
- 13: Fronten

## Patentansprüche

1. Klimagerät (1) zum Kühlen von Luft für einen Elektronikgeräteschrank (12) oder dergleichen, wobei das Klimagerät (1) ein Klimagerät zur Anordnung zwischen Elekronikgeräteschränken (12) oder dergleichen ist, aufweisend
- ein Gehäuse (2) mit einer Vorderseite (3) und einer der Vorderseite gegenüberliegenden Rückseite (4),
- mindestens ein Radialgebläse (5) und
- einen Wärmetauscher (6),
wobei der Wärmetauscher (6) mit einer externen Kühleinrichtung oder einer internen Kühleinrichtung zum Beaufschlagen des Wärmetauschers (6) mit gekühltem Kühlmedium in Verbindung steht,
wobei das Radialgebläse (5) Luft von der Rückseite (4) ansaugt, in Kontakt mit dem Wärmetauscher (6) bringt und zur Vorderseite (3) leitet und in radialer Richtung an der Vorderseite (3) abgibt, so dass der austretende Kühlluftstrom sich an den Oberflächen benachbarter Elektronikgeräteschränkefronten (13) entlang bewegen kann,
**dadurch gekennzeichnet, dass**
mindestens ein Blech (7) unterhalb oder oberhalb mindestens eines der Radialgebläse (5) angeordnet ist, wobei das Blech (7) drei miteinander verbundene Abschnitte (8, 9, 10) aufweist: einen ersten bogenförmigen Abschnitt (8), einen geraden Abschnitt (9) und einen zweiten bogenförmigen Abschnitt (10) und der erste (8) und zweite bogenförmige Abschnitt (10) punktsymmetrisch zueinander angeordnet sind und zueinander kongruent sind und entlang der Rundung der Radialgebläse (5) angeordnet sind.

2. Klimagerät (1) nach Anspruch 1, **dadurch gekennzeichnet, dass** der Querschnitt des Blechs (7) dem Graph einer Polynomfunktion x^{y} entspricht, mit y gleich einer Zahl von 3 bis 10, bevorzugt x³ entspricht.

3. Klimagerät (1) nach Anspruch nach 1, **dadurch gekennzeichnet, dass** der erste bogenförmige Abschnitt (8) und der zweite bogenförmige Abschnitt (10) einen Querschnitt in Form eines Viertelkreisbogens haben.

4. Klimagerät (1) nach Anspruch 1, **dadurch gekennzeichnet, dass** das Blech (7) einen wellenförmigen oder S-förmigen Querschnitt hat.

5. Klimagerät (1) nach einem der vorhergehenden Ansprüche, **dadurch gekennzeichnet, dass** das Klimagerät (1) drei Radialgebläse (5) und zwei Bleche (7) aufweist, wobei die beiden Bleche (7) jeweils zwischen zwei Radialgebläsen (5) angeordnet sind.

6. Klimagerät (1) nach einem der vorhergehenden Ansprüche, **dadurch gekennzeichnet, dass** das Klimagerät (1) mehrere zueinander beabstandete auf verschiedenen Höhen angeordnete Radialgebläse (5) aufweist.

7. Klimagerät (1) nach einem der vorhergehenden Ansprüche, **dadurch gekennzeichnet, dass** das Klimagerät (1) mindestens einen Temperatursensor zum Erfassen der Temperatur der einströmenden und/oder ausströmenden Luft an der Rückseite eines zu kühlenden Racks, an der Rückseite des Klimagerätes oder an der Austrittsseite des Wärmetauschers aufweist.

8. Klimagerät (1) nach einem der vorhergehenden Ansprüche, **dadurch gekennzeichnet, dass** das Klimagerät mehrere Temperatursensoren aufweist, die auf verschiedenen Höhen die Temperaturen erfassen und die erfassten Temperaturen zur individuelle Regelung der Luftvolumenströme und/oder der Wärmetauschersegmente verwenden.

## Claims

1. Air conditioning device (1) for the cooling of air for an electronics cabinet (12) or similar, in which the air conditioning device (1) is an air conditioning device for arrangement between electronics cabinets (12) or similar, embodying
- a housing (2) having a front side (3) and a back side (4) opposite the front side,
- at least one radial fan (5) and
- a heat exchanger (6),
in which the heat exchanger (6) is connected to an external cooling means or an internal cooling means for charging the heat exchanger (6) with a cooled cooling medium,
in which the radial fan (5) sucks in air from the back side (4), brings it into contact with the heat exchanger (6) and guides it to the front side (3) and passes it in a radial direction on the front side (3), so that the outflowing cool air stream can move along the surfaces of the fronts of the adjacent electronics cabinets (13),
**characterized in that**
at least one sheet (7) is arranged below or above at least one of the radial fans (5), in which the sheet (7) embodies three interconnected sections (8, 9, 10): a first curved section (8), a straight section (9) and a second curved section (10) and the first (8) and second curved sections (10) are arranged point-symmetrically to one another and are congruent to one another and are arranged along the curvature of the radial fans (5).

2. Air conditioning device (1) according to claim 1, **characterized in that** the cross section of the sheet (7) corresponds to the graph of a polynomial function x^{y}, with y equal to a number from 3 to 10, preferably corresponding to x³.

3. Air conditioning device (1) according to claim 1, **characterized in that** the first curved section (8) and the second curved section (10) have a cross section in the form of a quadrant arc.

4. Air conditioning device (1) according to claim 1, **characterized in that** the sheet (7) has a wave-shaped or S-shaped cross section.

5. Air conditioning device (1) according to any one of the preceding claims, **characterized in that** the air conditioning device (1) embodies three radial fans (5) and two sheets (7), in which the two sheets (7) are arranged in each case between two radial fans (5).

6. Air conditioning device (1) according to any one of the preceding claims, **characterized in that** the air conditioning device (1) embodies a plurality of radial fans (5) arranged spaced apart at different heights.

7. Air conditioning device (1) according to any one of the preceding claims, **characterized in that** the air conditioning device (1) embodies at least one temperature sensor to record the temperature of the inflowing and/or outflowing air at the back side of a rack to be cooled, at the back side of the air conditioning device or at the outlet side of the heat exchanger.

8. Air conditioning device (1) according to any one of the preceding claims, **characterized in that** the air conditioning device embodies a plurality of temperature sensors which record the temperatures at different heights and use the recorded temperatures for the individual regulation of the air volume flows and/or heat exchanger segments.

## Revendications

1. Appareil de climatisation (1) destiné au refroidissement d'air pour une armoire d'instruments électroniques (12) ou analogue, l'appareil de climatisation (1) étant un appareil de climatisation destiné à être disposé entre des armoires d'instruments électroniques (12) ou analogues, présentant
- un boîtier (2) doté d'une face avant (3) et d'une face arrière (4) située en vis-à-vis de la face avant,
- au moins un ventilateur radial (5) et
- un échangeur de chaleur (6),
l'échangeur de chaleur (6) étant relié à un dispositif de refroidissement externe ou un dispositif de refroidissement interne destiné à appliquer un fluide de refroidissement réfrigéré à l'échangeur de chaleur (6),
le ventilateur radial (5) aspirant de l'air depuis la face arrière (4), le mettant en contact avec l'échangeur de chaleur (6) et le dirigeant vers la face avant (3) et le délivrant dans la direction radiale sur la face avant (3), de sorte que le flux d'air de refroidissement sortant peut se déplacer sur les surfaces de façades d'armoires d'instruments électroniques (13) voisines,
**caractérisé en ce que**
au moins une tôle (7) est disposée au-dessous ou au-dessus d'au moins un des ventilateurs radiaux (5), la tôle (7) présentant trois parties (8, 9, 10) reliées les unes aux autres : une première partie (8) arquée, une partie (9) rectiligne et une deuxième partie (10) arquée, et la première (8) et la deuxième (10) partie arquées étant disposées l'une par rapport à l'autre de façon symétrique par rapport à un point et de façon congruente l'une avec l'autre et le long de l'arrondi des ventilateurs radiaux (5).

2. Appareil de climatisation (1) selon la revendication 1, **caractérisé en ce que** le profil de la tôle (7) correspond au graphe d'une fonction polynôme x^{y}, y correspondant à un nombre allant de 3 à 10, de préférence x³

3. Appareil de climatisation (1) selon la revendication 1, **caractérisé en ce que** la première partie (8) arquée et la deuxième partie (10) arquée présentent un profil ayant la forme d'un arc de quart de cercle.

4. Appareil de climatisation (1) selon la revendication 1, **caractérisé en ce que** la tôle (7) présente un profil en forme d'onde ou en forme de S.

5. Appareil de climatisation (1) selon l'une des revendications précédentes, **caractérisé en ce que** l'appareil de climatisation (1) présente trois ventilateurs radiaux (5) et deux tôles (7), les deux tôles (7) étant disposées respectivement entre deux ventilateurs radiaux (5).

6. Appareil de climatisation (1) selon l'une des revendications précédentes, **caractérisé en ce que** l'appareil de climatisation (1) présente plusieurs ventilateurs radiaux (5) disposés à distance les uns des autres, à des hauteurs différentes.

7. Appareil de climatisation (1) selon l'une des revendications précédentes, **caractérisé en ce que** l'appareil de climatisation (1) présente au moins un capteur de température destiné à mesurer la température de l'air entrant et/ou sortant, sur la face arrière d'une baie à refroidir, sur la face arrière de l'appareil de climatisation ou sur le côté de sortie de l'échangeur de chaleur.

8. Appareil de climatisation (1) selon l'une des revendications précédentes, **caractérisé en ce que** l'appareil de climatisation présente plusieurs capteurs de température qui mesurent les températures à différentes hauteurs et utilisent les températures mesurées pour la régulation individuelle des débits d'air volumiques et/ou des segments d'échangeur de chaleur.
